# EUROPÄISCHE PATENTSCHRIFT

(11) **EP 3 419 060 B1**
(45) Veröffentlichungstag und Bekanntmachung des Hinweises auf die Patenterteilung: **12.06.2019**
(21) Anmeldenummer: 18000531.6
(22) Anmeldetag: 18.06.2018
(51) Int. Cl.: H01L 31/0687, H01L 31/0304

(54) **SOLARZELLENSTAPEL**
SOLAR CELL STACK
EMPILEMENT DE CELLULES SOLAIRES

(30) Priorität: 21.06.2017 DE 102017005950
(43) Veröffentlichungstag der Anmeldung: 26.12.2018
(73) Patentinhaber: AZUR SPACE Solar Power GmbH, 74072 Heilbronn (DE)
(72) Erfinder: Ebel, Lars, 97249 Eisingen (DE); Guter, Wolfgang, 70190 Stuttgart (DE)
(74) Vertreter: Koch Müller Patentanwaltsgesellschaft mbH

(56) Entgegenhaltungen:
- EP-A1- 2 251 912
- JP-A- H0 964 386
- ANDREAS W. BETT ET AL: "Highest efficiency multi-junction solar cell for terrestrial and space applications", PROCEEDINGS OF THE 24TH EUROPEAN PHOTOVOLTAIC SOLAR ENERGY CONFERENCE AND EXHIBITION, 21. September 2009 (2009-09-21), - 25. September 2009 (2009-09-25), Seiten 1-6, XP040529663, Hamburg-GERMANY ISBN: 978-3-936338-25-6
- W. GUTER ET AL: "Investigation and development of III-V-triple-junction concentrator solar cells", PROCEEDINGS OF THE 22ND EUROPEAN PHOTOVOLTAIC SOLAR ENERGY CONFERENCE, 3. September 2007 (2007-09-03), - 7. September 2007 (2007-09-07), Seiten 122-125, XP040512959, Milan-ITALY ISBN: 978-3-936338-22-5

## Beschreibung

Die Erfindung betrifft einen Solarzellenstapel.

Ein derartiger Solarzellenstapel ist aus W. Guter et al, "Investigation and development of III-V-triple-junction concentrator solar cells", in 22nd European Photovoltaic Solar Energy Conference, 3-7 September 2007, Milan Italy, S.122-125, bekannt.

Aus A. Bett et al, "Highest efficiency multi-junction solar cell for terrestrial and space applications", in 24th European Photovoltaic Solar Energy Conference and Exhibition, 21-25 September 2009, Hamburg, Germany, Session 1AP.1.1, Pages 1-6, ist eine Mehrfachsolarzelle mit einer spannungskompensierten Tunneldiode bekannt.

Aus der EP 2 251 912 A1 ist eine stapelförmige monolithische Mehrfachsolarzelle mit verbesserter Stromleitung zwischen den Solarzellen bekannt. Hierzu wird zwischen zwei aufeinanderfolgenden Solarzellen eine Tunneldiode mit zueinander verspannten entarteten Schichten angeordnet. Eine tensil verspannte entartete Schicht ist mit einer kompressiv verspannten entarteten Schicht kompensiert. Die entarteten Schichten sind entweder als mit Kohlenstoff dotierte entartete p+- oder als mit Tellur oder Silizium dotierte entartete n+-Schichten ausgeführt. Indem die Verspannung kompensiert ist, wirkt keine Verspannung auf die die Tunneldiode umgebenden Schichten, anders ausgedrückt die Summe der Verspannung ist null.

In einer anderen Ausführungsform werden zur Spannungskompensation nicht nur die entarteten Schichten der Tunneldiode, sondern auch die die Tunneldiode unmittelbar umgebenden Schichten vorzugsweise Barriereschichten einbezogen. Während die entartete n+-Schicht immer unverspannt ist und die Gitterkonstante der unmittelbar anliegenden Barriereschicht aufweist, ist vorliegend immer die entartete p+-Schicht entweder tensil oder kompressiv verspannt. Entsprechend ist die an die entartete p+-Schicht anliegende Barriereschicht kompressiv oder tensil verspannt. Indem die Verspannung wiederum kompensiert ist, wirkt keine Verspannung auf die die Barriereschicht umgebenden Schichten, anders ausgedrückt die Summe der Verspannung ist null.

Das typische Vorgehen für Tunneldioden-Materialien neuer Solarzellkonzepte mit metamorphen Puffern Ist eine Gitteranpassung der Tunneldioden-Schichten an die Substratgitterkonstante bzw. an die neue virtuelle Substratgitterkonstante in metamorphen Strukturen. Gleichzeitig sollen die Tunneldioden-Schichten eine ausreichend hohe Dotierung für die Stromtragfähigkeit und eine ausreichend hohe Transparenz für darunterliegende Teilzellen aufweisen.

Im Falle der spannungskompensierten Tunneldioden im metamorphen Solarzellkonzept mit Indium-Gehalten deutlich größer als 5% kommt es zu einem großen Gitterkonstantenunterschied zwischen den sich kompensierenden entarteten p+- und n+-Schichten, z.B. spannungskompensierte Tunneldioden-Schichten aus EP 2 251 192 A1, so dass die tensil verspannte Tunneldioden-Schicht plastisch relaxiert und reißt. Die dadurch entstehenden Fadenversetzungen oder sogar Risse können bis zum p-n Übergang angrenzender Teilzellen hinein reichen und dort als Zentren für nichtstrahlende Rekombination der generierten Ladungsträger wirken, so dass die Effizienz der Mehrfachsolarzelle deutlich reduziert wird.

Wie aus W. Guter et al, "Investigation and development of III-V-triple-junction concentrator solar cells", in 22nd European Photovoltaic Solar Energy Conference, 3-7 September 2007, Milan Italy, S.122-125, bekannt ist, führt eine entartete p+-Schicht, bestehend aus AlInGaAs, mit hohem In-Gehalt in metamorphen Mehrfachsolarzell-Strukturen zwar zu einer verbesserten Gitterkonstantenanpassung zum virtuellen Substrat. Dieses Material ist jedoch im Vergleich zu AIGaAs schwer p-dotierbar. Bei extrinsischer Dotierung mittels Kohlenstofftetrabromid (CBr4) treten außerdem Vorreaktionen im MOVPE-Reaktor z.B. mit TMIn auf, was zu einem unterdrückten In-Einbau und somit zu einer schlechten Gitteranpassung führt.

In der Folge relaxiert die entartete p+-Schicht plastisch und erzeugt Fadenversetzungen oder Risse und bewirkt eine Reduzierung der Effizienz der metamorphen Mehrfachsolarzelle.

Ein alternatives, p-dotiertes Tunneldioden-Material stellt (Al)GaAsSb dar. Dieses Materialsystem kann durch das As/Sb-Verhältnis auf verschiedene Gitterkonstanten angepasst und gleichzeitig hoch p-dotiert werden (z.B. intrinsischer Kohlenstoff oder CBr4 Dotierung). (Al)GaAsSb wird also zur Herstellung gitterangepasster Tunneldiodenstrukturen verwendet. Allerdings ist für dieses Materialsystem im Vergleich zu Arseniden und Phosphiden oftmals eine spezielle Konfiguration des MOVPE (metallorganische Gasphasenepitaxie) Reaktors und spezielle Ausgangsmaterialien notwendig.

Vor diesem Hintergrund besteht die Aufgabe der Erfindung darin, eine Vorrichtung anzugeben, die den Stand der Technik weiterbildet und insbesondere die Effizienz der metamorphen Solarzellen durch eine bessere Gitteranpassung der p+-Schicht erhöht und gleichzeitig die Stromtragfähigkeit der Tunneldiode möglichst wenig reduziert.

Die Aufgabe wird durch einen Solarzellenstapel mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellenstapel mit einer überwiegenden Anzahl von III-V Halbleiterschichten bereitgestellt, wobei der Solarzellenstapel eine erste Teilzelle mit einer ersten Bandlücke und mit einer ersten Gitterkonstanten, und eine zweite Teilzelle mit einer zweiten Bandlücke und mit einer zweiten Gitterkonstanten aufweist.

Zwischen den beiden Solarzellen ist eine Zwischenschichtfolge angeordnet. Die Zwischenschichtfolge weist eine erste Barriereschicht und eine erste Tunneldiode und eine zweite Barriereschicht auf, wobei die Schichten in der genannten Reihenfolge angeordnet sind.

Die Tunneldiode weist eine entartete n+-Schicht mit einer dritten Gitterkonstanten und eine entartete p+-Schicht mit einer vierten Gitterkonstanten auf, wobei die vierte Gitterkonstante kleiner als die dritte Gitterkonstante ist und die erste Bandlücke kleiner ist als die zweite Bandlücke ist und die p+-Schicht eine andere Materialkomposition mit Indium als die n+-Schicht aufweist. Die n+-Schicht ist zwischen der ersten Barriereschicht und der p+-Schicht angeordnet. Die p+-Schicht ist zwischen der n+-Schicht und der zweiten Barriereschicht angeordnet.

In einer ersten Alternative sind die erste Teilzelle und die zweite Teilzelle zueinander gitterangepasst, und die p+-Schicht weist eine kleinere Gitterkonstante mit einer Gitterfehlanpassung von mindestens 0,5% auf.

In einer zweiten Alternative ist zwischen der ersten Teilzelle und der zweiten Teilzelle ein metamorpher Puffer ausgebildet, wobei die entartete p+-Schicht der Tunneldiode weder zu der ersten Teilzelle noch zu der zweiten Teilzelle gitterangepasst ist. Vorzugsweise liegt die vierte Gitterkonstante zwischen der ersten Gitterkonstante und der zweiten Gitterkonstante.

Die dritte Gitterkonstante der entarteten n+-Schicht der Tunneldiode ist gitterangepasst zu der ersten Teilzelle oder zu der zweiten Teilzelle.

Für beide Alternativen gilt, dass die entartete p+-Schicht eine andere Materialkombination als die entartete n+-Schicht aufweist.

Die entartete p+-Schicht enthält mindestens 5% Indium und als Dotierstoff Kohlenstoff.

Die Schichten der Tunneldiode und die weiteren Schichten der Zwischenschichtfolge sind zueinander nicht spannungskompensiert.

Es sei angemerkt, dass mit dem Begriff der Gitteranpassung ein Unterschied in den Gitterkonstanten von zwei aufeinanderfolgenden Schichten kleiner als 0,1% verstanden ist.

Mit dem Begriff "nicht spannungskompensiert" ist verstanden, dass durch die Gitterfehlanpassung der entarteten p+-Schicht eine Verspannung erzeugt ist und die Verspannung nicht durch die entartete n+-Schicht oder mittels der Barriereschichten kompensiert wird.

Anders ausgedrückt die dritte Gitterkonstante oder die Gitterkonstanten der beiden Barriereschichten sind gleich entweder zu der ersten Gitterkonstante oder gleich zu der zweiten Gitterkonstante.

Es versteht sich, dass mit dem Begriff "überwiegend III-V Halbleiterschichten" eine Mehrfachsolarzelle bezeichnet wird, von deren Schichten mehr als 50 % vorzugsweise mehr als 80% aus III-V Materialien bestehen.

Eine derartige Teilzelle umfasst insbesondere oft auch eine Ge-Teilzelle, wobei die weiteren Teilzellen des Solarzellenstapels aus den III-V Materialien bzw. Verbindungen bestehen.

Es versteht sich weiterhin, dass der Begriff der Teilzelle synonym mit dem Begriff der Teilsolarzelle verwendet wird. Anders ausgedrückt besteht der Solarzellenstapel aus mehreren Teilsolarzellen, die miteinander mittels Tunneldioden in Serie verschaltet sind.

Es sei angemerkt, dass mit dem Begriff der Materialkomposition, beispielsweise eine InGaAs-Materialkomposition, eine Verbindung aus den angeführten Elementen bezeichnet wird, wobei zusätzlich zu den angeführten Elementen auch weitere Elemente umfasst sein können.

Bestehen Schichten aus einer gegebenen Materialkomposition, versteht es sich, dass zusätzlich zu der angeführten Materialkomposition insbesondere Dotierstoffe wie beispielsweise Zink oder Kohlenstoff mitumfasst sind, ohne dass die Dotierstoffe explizit erwähnt sind.

Es sei angemerkt, dass mit dem Begriff der entarteten Schicht vorliegend eine hochdotierte Tunneldioden-Schicht verstanden wird. Der Begriff der Entartung bezieht sich also darauf, dass das Fermi-Niveau der n+-Schicht in dem Leitungsband und das Fermi-Niveau der p+-Schicht in dem Valenzband liegt, d.h. die Halbleiterschichten eine metallische Leitfähigkeit aufweisen.

Des Weiteren sei angemerkt, dass die unmittelbar die Tunneldiode umgebenden Schichten, insbesondere die Barriereschichten nicht verspannt sind. Bezogen auf die Zwischenschichtfolge ist ausschließlich die entartete p+-Schicht der Tunneldiode gegenüber den Barriereschichten bzw. gegenüber wenigstens einer der Gitterkonstanten der Teilzellen gitterfehlangepasst und weist hierdurch eine tensile Verspannung auf. Anders ausgedrückt, die Barriereschichten weisen die Gitterkonstanten von benachbarten Teilzellen auf.

Überraschenderweise hat sich gezeigt, dass es möglich ist, das Material der entarteten p+-Schicht einer verspannten Tunneldiode für metamorphe Mehrfachsolarzellen, entgegen des Stands der Technik, so herzustellen, dass einerseits die Gitterfehlanpassung der entarteten p+-Schicht durch den Einbau von Indium und gleichzeitiger intrinsischer Kohlenstoffdotierung verringert wird, und sich andererseits die Transparenz und die elektrische Leitfähigkeit der Tunneldiode nicht merklich verringert.

Insbesondere lässt sich somit ein Kompromiss aus genügend hoher Gitteranpassung und genügend hoher p-Dotierung und genügend hoher Transparenz der p+-Schicht erreichen. Hierdurch wird die plastische Relaxation der p+-Schicht mit der Entstehung von Versetzungen oder Rissen vermieden und die Materialqualität der angrenzenden Teilzellen erhöht. Ferner wird der Wirkungsgrad der metamorphen Mehrfachsolarzelle erhöht.

Ein weiterer Vorteil ist, dass sich mittels beider Alternativen die Verspannung und hierdurch die Krümmung der Wafer reduzieren lässt. Indem die n+-Schicht zu einer der Teilzellen oder zu beiden Teilzellen gitterangepasst ist, d.h. die gleiche oder nahezu die gleiche Gitterkonstante wie eine Teilzelle oder wie beide Teilzellen aufweist, geht von der p+-Schicht der Tunneldiode und hierdurch von der Zwischenschichtfolge immer in Summe eine tensile Verspannung aus. Das heißt, die p+-Schicht der Tunneldiode ist tensil verspannt, wobei die umliegenden Schichten zu einer der Teilzellen oder zu beiden Teilzellen gitterangepasst und somit unverspannt sind.

Die Verspannung wird also vorliegend nicht in der Zwischenschichtfolge kompensiert, sondern vorzugsweise wenigstens teilweise durch andere Schichten des Solarzellenstapels. Ein Vorteil ist, dass sich mit der Verspannung der p+-Schicht die während des Epitaxieprozesses sowohl vor der Herstellung als auch nach der Herstellung der Zwischenschichtfolge eingebaute kompressive Verspannungen wenigstens teilweise kompensieren.

Ein weiterer Vorteil insbesondere der zweiten Alternative ist, dass gerade bei einem Einbau eines metamorphen Puffers zwischen der ersten Teilzelle und der zweiten Teilzelle und der zumeist aus dem Einbau des Puffers resultierenden Restverspannung des Wafers mittels der entarteten p+-Schicht der Tunneldiode, deren Gitterkonstante weder zu der ersten Teilzelle noch zu der zweiten Teilzelle gitterangepasst ist, eine wenigstens teilweise Kompensation durchführen lässt.

In einer Ausführungsform weist die entartete p+-Schicht der Tunneldiode eine Gitterfehlanpassung zu der entarteten n+-Schicht der Tunneldiode zwischen 0.5% und 2.0% auf.

In einer Weiterbildung besteht die entartete p+-Schicht der Tunneldiode aus einer Materialkomposition von AlInGaAs, wobei die Kohlenstoffkonzentration in dem Material größer als 1E19 cm-3 ist. In einer anderen Weiterbildung liegt der Indium-Gehalt der entarteten p+-leitenden AlInGaAs Schicht der Tunneldiode zwischen 5% und 20%, wobei der Aluminium-Gehalt der entarteten p+-leitenden Schicht zwischen 10% und 80% liegt.

Vorzugsweise liegt die Gitterkonstante der entarteten p+-leitenden Schicht der Tunneldiode zwischen 5.674 Å und 5.734 Å. Vorzugsweise wird die Gitterkonstante auch durch den Indium-Gehalt beeinflusst. In einer anderen Ausführungsform enthält die entartete p+-Schicht der Tunneldiode kein Antimon oder bis zu maximal 5% Antimon.

In einer Ausführungsform besteht die entartete n+-leitende Schicht der Tunneldiode aus einer Verbindung aus InGaP oder AlInGaP oder AlInP und ist mit Tellur, Silizium, Selen oder Germanium dotiert, wobei die Gitterkonstante zwischen 5.714 Å und 5.785 Å liegt. Vorzugsweise liegt der Indium-Gehalt der entarteten n+-leitenden Schicht der Tunneldiode zwischen 63% und 80%. Der Aluminium-Gehalt beträgt maximal 37%. In einer Ausführungsform liegt für InAlP der Indium-Gehalt bei max. 63 % und der Aluminium-Gehalt bei max. 37%. In einer anderen Ausführungsform liegt für InAlP der Indium-Gehalt bei ca. 70 % und der Aluminium-Gehalt bei max. ca. 30 %.

Es versteht sich, dass die Prozentzahlen der angegebenen Indium- und Aluminium-Gehalte auf den Gesamtgehalt der Gruppe-III Atome bezogen sind.

D.h. bei der Verbindung Al_{y}InₓGa_{1-x-y}As beträgt der Indium-Gehalt den Wert X und der Aluminium-Gehalt den Wert Y und hierdurch ergibt sich z.B. für einen Indium-Gehalt von 15% ein X-Wert von 0,15 und für einen Aluminium-Gehalt von maximal 85% ein Y-Wert von maximal 0,85.

In einer Ausführungsform weist der Solarzellenstapel ein Ge- oder ein GaAs-Substrat auf.

Vorzugsweise weist das Ge Substrat an der Oberseite, d.h. gegen die Richtung des Lichteinfalls eine n-dotierte Schicht auf. Hierbei ist die Ge-Teilzelle als unterste Teilzelle ausbildet.

In einer anderen Weiterbildung umfasst der Solarzellenstapel genau drei Teilzellen, wobei zwischen der zweiten Teilzelle und der dritten Teilzelle eine weitere Tunneldiode ausgebildet ist. Es versteht sich, dass sich die Verspannungen der beiden Tunneldioden nicht kompensieren. Alternativ ist nur eine der zwei Tunneldioden verspannt. Vorzugsweise ist die Tunneldiode zwischen der zweiten Teilzelle und der dritten Teilzelle nicht verspannt.

In einer Ausführungsform ist in der stapelförmig aufrecht metamorphen vierfachen Mehrfachsolarzelle die verspannte Tunneldiode ein- bis zweimal vorhanden. Es versteht sich, dass die verspannten Tunneldioden jeweils zwischen zwei unmittelbar aufeinanderfolgenden Teilzellen angeordnet sind. Vorzugsweise sind drei der vier Teilzellen oberhalb des metamorphen Puffers angeordnet. Vorzugsweise ist zwischen der untersten Teilzelle und dem metamorphem Puffer eine nichtverspannte Tunneldiode ausgebildet.

In einer Weiterbildung ist die verspannte Tunneldiode ein- bis dreimal in der stapelförmig aufrecht metamorphen vierfachen Mehrfachsolarzelle vorhanden. Eine der verspannten Tunneldiode befindet sich zwischen dem metamorphem Puffer und der oberhalb des metamorphen Puffers liegenden Teilzelle. Drei der vier Teilzellen sind oberhalb des metamorphen Puffers angeordnet, wobei jeweils zwischen benachbarten Teilzellen eine verspannte Tunneldiode angeordnet ist. Einzelne verspannte Tunneldioden können natürlich durch gitterangepasste Tunneldioden oder weitere Tunneldioden ersetzt werden.

In einer anderen Ausführungsform ist die verspannte Tunneldiode ein- bis dreimal in der stapelförmig aufrecht metamorphen fünffachen Mehrfachsolarzelle vorhanden und befindet sich jeweils zwischen zwei Teilzellen, wobei vier der fünf Teilzellen oberhalb des metamorphen Puffers angeordnet sind. Vorzugsweise ist zwischen der untersten Teilzelle und dem metamorphem Puffer eine nichtverspannte Tunneldiode ausgebildet. Einzelne verspannte Tunneldioden können natürlich durch gitterangepasste Tunneldioden oder weitere Tunneldioden ersetzt werden.

In einer Weiterbildung ist die verspannte Tunneldiode ein- bis viermal in einer stapelförmig aufrecht metamorphen fünffachen Mehrfachsolarzelle vorhanden, wobei vier der fünf Teilzellen oberhalb des metamorphen Puffers angeordnet sind. Die verspannte Tunneldiode ist zwischen dem metamorphen Puffer und der sich anschließenden Teilzelle ausgebildet und jeweils zwischen zwei benachbarten Teilzellen oberhalb des metamorphen Puffers angeordnet. Einzelne verspannte Tunneldioden können natürlich durch gitterangepasste Tunneldioden oder weitere Tunneldioden ersetzt werden.

In einer Ausführungsform bestehen die Schichten des metamorphen Puffers in der zweiten Ausführungsform aus Materialkompositionen von InGaAs und/oder AlInGaAs und/oder InGaP, wobei der metamorphe Puffer eine Abfolge von mindestens drei Schichten aufweist und die Gitterkonstante bei der Abfolge in Richtung zu der zweiten Teilzelle von Schicht zu Schicht ansteigt und wobei die Gitterkonstanten der Schichten des Puffers größer als die Gitterkonstante der ersten Teilzelle sind und wobei eine Schicht des metamorphen Puffers eine dritte Gitterkonstante aufweist und die dritte Gitterkonstante größer als die Gitterkonstante der zweiten Teilzelle ist. Vorzugsweise weist der metamorphe Puffer eine Abfolge von wenigstens fünf Schichten oder genau fünf Schichten auf. In einer Weiterbildung weist bei dem metamorphen Puffer eine der Schichten eine kompressive Verspannung auf.

In einer Weiterbildung ist die entartete p+-Schicht der Tunneldiode weder von einer in Bezug auf die Tunneldiode darauffolgenden Schicht noch von einer in Bezug auf die Tunneldiode vorangegangenen Schicht spannungskompensiert. Es versteht sich, dass mit dem Begriff der drauffolgenden Schichten hiermit Schichten bezeichnet werden, welche während des Epitaxieprozesses erst nach der p+-Schicht abgeschieden werden. In einer Ausführungsform ist der Solarzellenstapel monolithisch aufgebaut.

Ferner sei angemerkt, dass sich die neuartige Tunneldiode, welche eine tensile Verspannung erzeugt, sowohl bei aufrecht gewachsenen als auch bei invertiert gewachsenen Mehrfachsolarzellen vorteilhaft einsetzen lässt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt, die:
- Figur 1: einen Solarzellenstapel mit zwei Teilzellen und mit einer erfindungsgemäßen Tunneldiode,
- Figur 2: ein Diagramm mit qualitativem Zusammenhang zwischen Indium- und Kohlenstoff-Gehalt sowie der Transparenz und der Relaxationswahrscheinlichkeit für die entartete p+-Schicht der Tunneldiode,
- Figur 3: einen Solarzellenstapel mit zwei Teilzellen und mit einer erfindungsgemäßen Tunneldiode und einem metamorphen Puffer,
- Figur 4: einen Solarzellenstapel mit drei Teilzellen und mit zwei erfindungsgemäßen Tunneldioden,
- Figur 5: einen Solarzellenstapel mit vier Teilzellen und mit zwei erfindungsgemäßen Tunneldioden und einer Tunneldiode nach dem Stand der Technik,
- Figur 6: einen Solarzellenstapel mit vier Teilzellen und mit zwei erfindungsgemäßen Tunneldioden und einer Tunneldiode nach dem Stand der Technik und einem metamorphen Puffer.
- Figur 7: einen Solarzellenstapel mit fünf Teilzellen und mit drei erfindungsgemäßen Tunneldioden und einer Tunneldiode nach dem Stand der Technik und einem metamorphen Puffer.

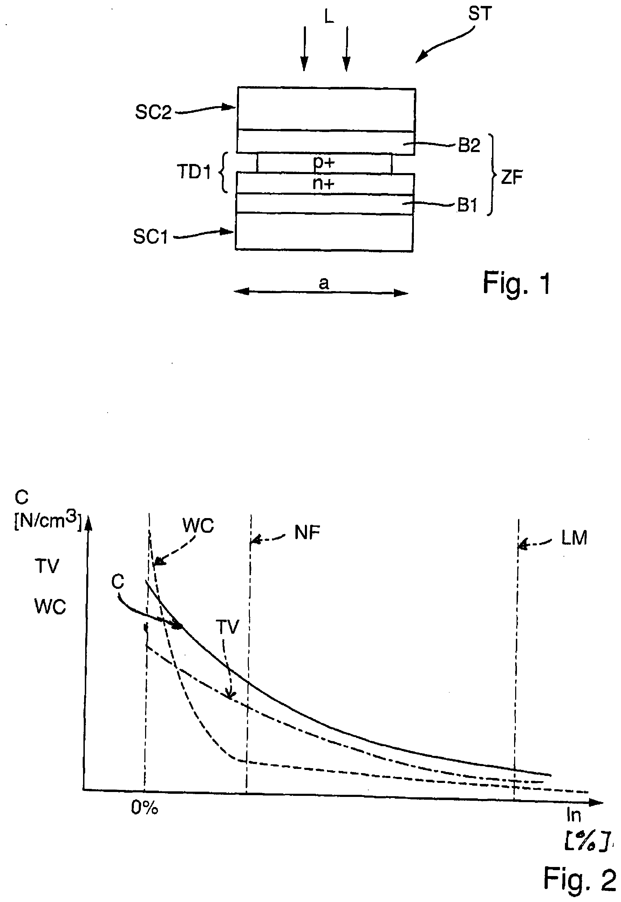

Die Figur 1 zeigt einen Solarzellenstapel ST mit einer ersten Teilzelle SC1 und einer zweiten Teilzelle SC2 und mit einer erfindungsgemäßen Tunneldiode TD1. Der Solarzellenstapel ST weist überwiegend III-V Halbleiterschichten auf. Hierbei findet der Lichteinfall L durch die zweite Solarzelle SC2 statt.

Unterhalb des abgebildeten Solarzellenstapels ST ist die Größe der Gitterkonstanten a mit einem Pfeil veranschaulicht. Anders ausgedrückt die dargestellte laterale Ausdehnung der einzelnen Schichten, also die Ausdehnung in Richtung des Pfeiles korrespondiert mit der Größe der Gitterkonstante.

Die erste Teilzelle SC1 weist eine erste Bandlücke mit einer ersten Gitterkonstante auf. Die zweite Teilzelle SC2 weist eine zweite Bandlücke mit einer zweiten Gitterkonstante auf. Vorzugsweise weist die zweite Teilzelle SC2 eine gleich große oder größere Bandlücke als die erste Teilzelle SC1 auf.

Zwischen den beiden Teilzellen SC1 und SC2 ist eine Zwischenschichtfolge ZF angeordnet. Die Zwischenschichtfolge ZF weist eine erste Barriereschicht B1 und die Tunneldiode TD1 mit einer entarteten n+-Schicht mit einer dritten Gitterkonstanten und einer entarteten p+-Schicht mit einer vierten Gitterkonstanten und eine zweite Barriereschicht B2 auf, wobei die Schichten in der genannten Reihenfolge angeordnet sind.

Die vierte Gitterkonstante ist kleiner als die dritte Gitterkonstante. Auch ist die erste Bandlücke kleiner als die zweite Bandlücke. Die entartete p+-Schicht weist eine andere Materialkomposition als die entartete n+-Schicht auf. Auch weist die p+-Schicht eine kleinere Gitterkonstante mit einer Gitterfehlanpassung von mindestens 0.5% zu der n+-Schicht auf.

Die Schichten der Tunneldiode TD1 und die weiteren Schichten der Zwischenschichtfolge ZF d.h. die beiden Barriereschichten B1 und B2 sind zueinander nicht spannungskompensiert.

Vorliegend enthält die entartete p+-Schicht neben Indium auch Kohlenstoff als Dotierstoff.

In der vorliegenden Ausführungsform, welche als erste Alternative bezeichnet ist gilt, dass die erste Teilzelle SC1 und die zweite Teilzelle SC2 zueinander gitterangepasst sind, d.h. die beiden Gitterkonstanten sind gleich. Auch die entartete n+-Schicht ist gitterangepasst zu den beiden Teilzellen SC1 und SC2.

Im Ergebnis weist der Solarzellenstapel ST eine mittels der entarteten p+-Schicht bewirkte tensile Verspannung auf.

In der Abbildung der Figur 2 ist der qualitative Zusammenhang zwischen Indium- und Kohlenstoff-Gehalt und der Relaxationswahrscheinlichkeit für die entartete p+-Schicht der Tunneldiode dargestellt.

Im Diagramm stellt die Abszisse den Indium-Gehalt qualitativ dar, während die Ordinate den qualitativen Kohlenstoff-Gehalt C und die Risswahrscheinlichkeit WC widerspiegelt.

Die durchgezogene Linie stellt hierbei den aktiven Kohlenstoff-Gehalt C in Abhängigkeit vom Indium-Gehalt dar. Die Risswahrscheinlichkeit WC in Abhängigkeit vom Indium-Gehalt wird durch die gestrichelte Linie dargestellt.

Die Transparenz TV der p+-Schicht in Abhängigkeit vom Indium-Gehalt wird qualitativ durch die Strichpunkt-Linie veranschaulicht.

Für den Fall, dass ein Indium-Gehalt nahe 0% in der p+-Schicht der Tunneldiode gewählt wird, weist die p+-Schicht eine hohe Kohlenstoff-Dotierung auf. Gleichzeitig liegt dieses Material sehr weit von der Gitteranpassung LM zu mindestens einer der angrenzenden Teilzellen entfernt, so dass die Risswahrscheinlichkeit WC ebenfalls sehr hoch ist. Die Transparenz TV der p+-Schicht bei einem Indium-Gehalt nahe 0% ist hingegen hoch.

Im entgegengesetzten Fall ist die p+-Schicht mit einem hohen Indium-Gehalt gitterangepasst LM zu mindestens einer der angrenzenden Tellzellen. Hierbei ist dementsprechend die Kohlenstoff-Dotierung und die Risswahrscheinlichkeit minimiert, so dass die Tunneldiode den Kristall zwar wenig stört, aber nicht mehr ausreichend stromtragfähig ist.

Gleichzeitig ist im gitterangepassten Fall die Transparenz TV der p+-Schicht niedrig, so dass das eingestrahlte Licht ungünstigerweise verstärkt in dieser Schicht absorbiert wird.

Die entartete p+-Schicht der erfindungsgemäßen Tunneldiode ist vom Indium-Gehalt am Punkt NF so gewählt, dass sowohl eine genügend hohe Kohlenstoff-Dotierung im Material eingebaut wird als auch eine niedrige Rissbildungswahrscheinlichkeit besteht und gleichzeitig eine genügend hohe Transparenz gewährleistet wird.

Entscheidend ist hierbei, dass die Abhängigkeit der Rissbildungswahrscheinlichkeit sowie die Abhängigkeit der Kohlenstoff-Dotierung und die Abhängigkeit der Transparenz qualitativ unterschiedlich vom In-Gehalt abhängen.

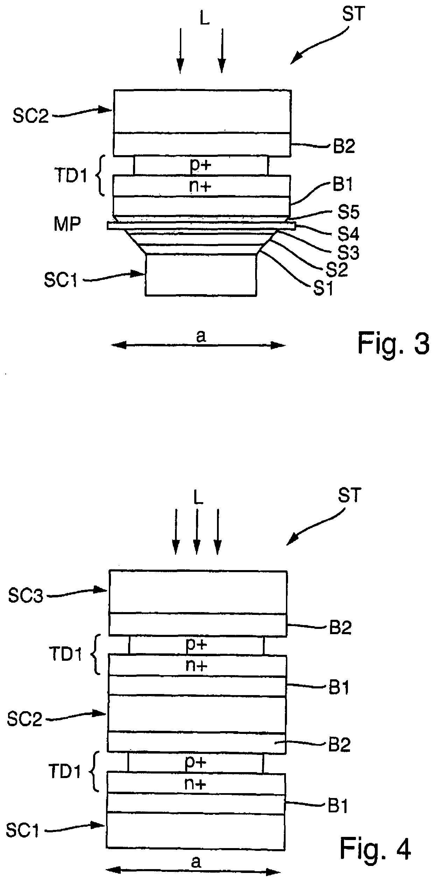

In der Abbildung der Figur 3 ist gemäß einer zweiten Alternative ein Solarzellenstapel ST mit zwei Teilzellen SC1 und SC2 und mit einer erfindungsgemäßen Tunneldiode TD1 und mit einem metamorphen Puffer MP dargestellt. Im Folgenden werden nur die Unterschiede zu der Abbildung der Figur 1 erläutert.

Die erste Teilzelle SC1 weist eine kleinere Gitterkonstante als die zweite Teilzelle SC2 auf.

Zwischen der ersten Teilzelle SC1 und der zweiten Teilzelle SC2 ist ein metamorpher Puffer MP ausgebildet. Vorliegend umfasst der metamorphe Puffer eine unmittelbar oberhalb der ersten Teilzelle SC1 angeordnete erste Schicht S1 und eine zweite Schicht S2 und eine dritte Schicht S3 und eine vierte Schicht S4 und eine fünfte Schicht S5, wobei die Schichten S1 - S5 in der genannten Reihenfolge angeordnet sind.

Die erste Schicht S1 ist gitterangepasst an die erste Teilzelle SC1. Die fünfte Schicht S5 ist gitterangepasst zu der zweiten Teilzelle SC2. Die zweite Schicht S2 weist eine größere Gitterkonstante als die erste Schicht S1 auf. Die dritte Schicht S3 weist eine größere Gitterkonstante als die zweite Schicht S2 auf. Die vierte Schicht S4 weist eine größere Gitterkonstante als die dritte Schicht S3 auf, während die Gitterkonstante der fünften Schicht S5 kleiner ist als die Gitterkonstante der vierten Schicht S4.

Es sei angemerkt, dass sich auch metamorphe Puffer MP mit mehr oder weniger als fünf Schichten ausbilden lassen.

Die Tunneldiode TD1 ist zwischen dem metamorphen Puffer MP und der zweiten Teilzelle SC2 angeordnet.

Die entartete n+-Schicht der Tunneldiode TD1 ist zu der zweiten Teilzelle SC2 gitterangepasst. Die entartete p+-Schicht der Tunneldiode TD1 ist weder zu der ersten Teilzelle SC1 noch zu der zweiten Teilzelle SC2 gitterangepasst.

In der Abbildung der Figur 4 ist ein Solarzellenstapel ST mit drei Teilzellen SC1 - SC3 und mit zwei erfindungsgemäßen Tunneldioden TD1 dargestellt. Im Folgenden werden nur die Unterschiede zu der Abbildung der Figur 1 erläutert.

Alle drei Teilzellen SC1- SC3 des Solarzellenstapels ST sind zueinander gitterangepasst.

Oberhalb der zweiten Solarzelle SC2 ist eine weitere Zwischenschichtfolge mit einer weiteren ersten Barriereschicht B1 und einer weiteren Tunneldiode TD1 und einer weiteren zweiten Barriereschicht B2 angeordnet.

Oberhalb der weiteren Zwischenschichtfolge ist eine dritte Teilzelle SC3 angeordnet. Der Lichteinfall L findet durch die dritte Teilzelle SC3 statt.

Indem zwei verspannte Tunneldioden TD1 eingebaut sind, addiert sich auch die mittels der beiden p+-Schichten bewirkte tensile Verspannung.

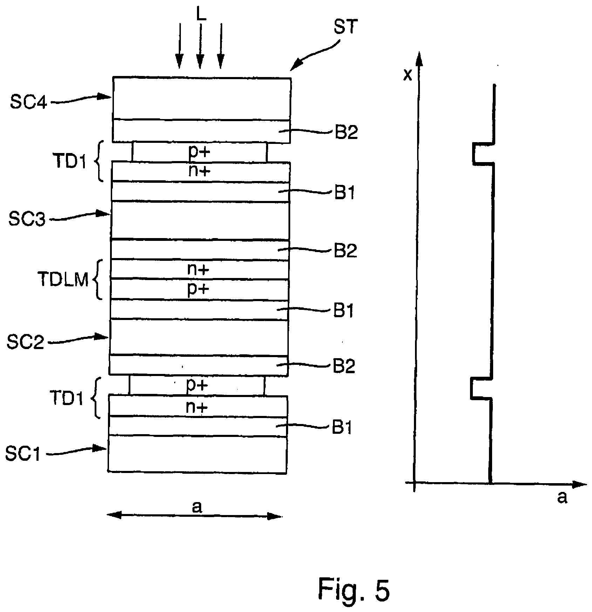

In der Abbildung der Figur 5 ist ein Solarzellenstapel ST mit vier Teilzellen SC1 - SC4 und mit zwei erfindungsgemäßen Tunneldioden TD1 und einer nicht verspannten Tunneldiode TDLM dargestellt. Im Folgenden werden nur die Unterschiede zu der Abbildung der Figur 4 erläutert.

Oberhalb der weiteren Zwischenschichtfolge ist eine vierte Teilzelle SC4 angeordnet. Der Lichteinfall L findet durch die vierte Teilzelle SC4 statt. Alle vier Teilzellen SC1- SC4 des Solarzellenstapels ST sind zueinander gitterangepasst.

Zwischen der zweiten Teilzelle SC2 und der dritten Teilzelle SC3 ist eine unverspannte Tunneldiode TDLM angeordnet. Beide entartenten Schichten der Tunneldiode TDLM sind gitterangepasst zu den Teilzellen SC1-SC4.

Indem wie in der Ausführungsform, dargestellt in der Figur 4, zwei verspannte Tunneldioden TD1 eingebaut sind, addiert sich auch die mittels der beiden p+-Schichten bewirkten tensilen Verspannung.

Zur Veranschaulichung der Gitteranpassung ist rechts neben der Darstellung des Solarzellenstapels ST auch der Verlauf der Höhe der Gitterkonstanten dargestellt. Es zeigt sich, dass bei den beiden verspannten Tunneldioden TD1 sich jeweils eine tensile Verspannung ergibt, so dass der Solarzellenstapel insgesamt wenigstens in erster Näherung die Summe der tensilen Verspannung aus den beiden verspannten Tunneldioden TD1 aufweist.

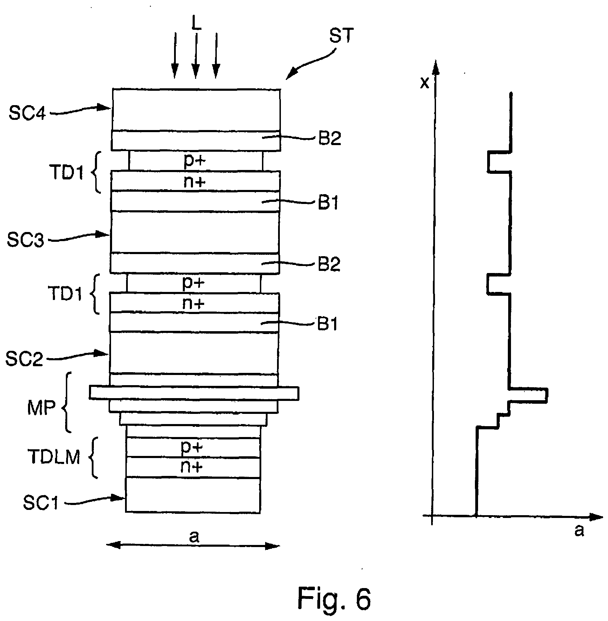

In der Abbildung der Figur 6 ist ein Solarzellenstapel ST mit vier Teilzellen SC1 - SC4 und mit zwei erfindungsgemäßen Tunneldioden TD1 und einem metamorphen Puffer MP und einer nicht verspannten Tunneldiode TDLM dargestellt. Im Folgenden werden nur die Unterschiede zu der Abbildung der Figur 3 und der Figur 5 erläutert.

Oberhalb des metamorphen Puffers MP sind die drei Teilzellen SC2- SC4 des Solarzellenstapels ST zueinander gitterangepasst.

Die Tunneldiode TDLM nach dem Stand der Technik ist zwischen der ersten Teilzelle SC1 und dem metamorphen Puffer MP1 angeordnet.

Zwischen der zweiten Teilzelle SC2 und der dritten Teilzelle SC3 ist eine erste verspannte Tunneldiode TD1 und zwischen der dritten Teilzelle SC3 und der vierten Teilzelle SC4 eine weitere zweite verspannte Tunneldiode TD1 angeordnet.

In der Darstellung des Verlaufs der Gitterkonstanten a rechts neben des Stapels zeigt sich deutlich, dass mittels der beiden tensil verspannten Tunneldiodenschichten der TD1 sich die kompressive Verspannung, bewirkt durch die große Gitterkonstante der vierten Schicht S4 des metamorphen Puffers MP, auf einfache Weise ohne zusätzliche Schichten wenigstens teilweise oder vollständig kompensieren lässt.

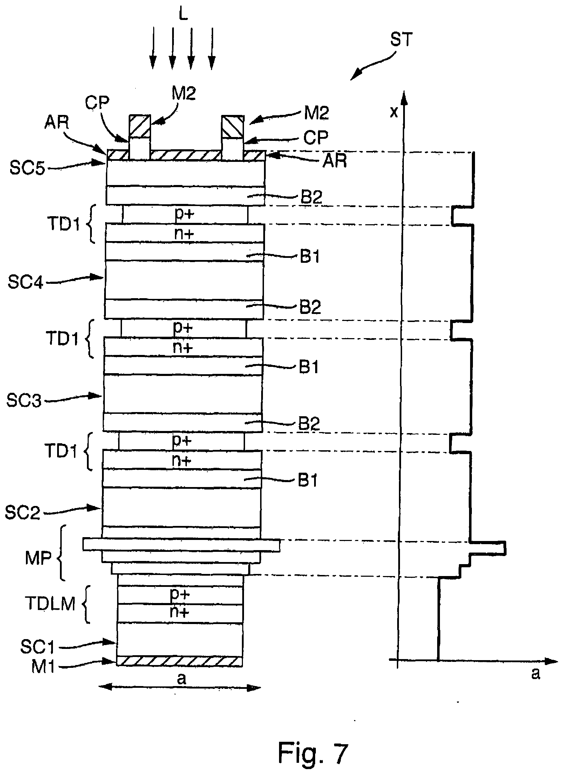

In der Abbildung der Figur 7 ist ein Solarzellenstapel ST mit fünf Teilzellen SC1 - SC5 und mit drei erfindungsgemäßen Tunneldioden TD1 und einem metamorphen Puffer MP und einer nicht verspannten Tunneldiode TDLM dargestellt. Im Folgenden werden nur die Unterschiede zu der Abbildung der Figur 6 erläutert.

Oberhalb der vierten Teilzellen SC4 ist eine weitere gitterangepasste fünfte Teilzelle SC5 ausgebildet. Anders ausgedrückt sind die zweite Teilzelle SC2 bis einschließlich der fünften Teilzelle SC5 des Solarzellenstapels ST zueinander gitterangepasst.

Zwischen der vierten Teilzelle SC4 und der fünften Teilzelle SC5 ist eine weitere dritte verspannte Tunneldiode TD1 angeordnet.

In der Darstellung des Verlaufs der Gitterkonstanten a rechts neben des Stapels zeigt sich, dass mittels der drei tensil verspannten Tunneldiodenschichten der TD1 sich die kompressive Verspannung, bewirkt durch die große Gitterkonstante der vierten Schicht S4 des metamorphen Puffers MP, ohne zusätzliche Schichten wenigstens teilweise oder vollständig kompensieren lässt.

An der Unterseite des Solarzellenstapels ST ist eine erste ganzflächige Metallkontaktanschlussschicht M1 ausgebildet. Auf der Oberseite des Solarzellenstapels ST, d.h. die Seite an der das Licht L zuerst auf den Solarzellenstapels ST auftrifft, ist eine Antireflexschicht AR mittels eines Maskenprozesses aufgebracht.

Die Antireflexschicht ist für die Ausbildung einer fingerartigen Leiterbahnstruktur unterbrochen. Die Leiterbahnstruktur umfasst eine auf der Oberseite der fünften Teilzelle SC5 angeordnete elektrisch leitfähige Abschlussschicht CP und einer oberhalb der Anschlussschicht ausgebildeten zweiten Metallkontaktanschlussschicht M2 auf.

Es versteht sich, dass es vorteilhaft ist zur Erhöhung der Strahlungsstabilität bei den vorgenannten Ausführungsformen einen Braggspiegel unterhalb einer Teilzelle anzuordnen. Mittels des Einbaus eines Braggspiegels lassen sich die Schichtdicken der jeweiligen Teilzelle um wenigstens 30% gegenüber einer Teilzelle ohne einen Braggspiegel reduzieren.

## Patentansprüche

1. Solarzellenstapel (ST) aufweisend überwiegend III-V Halbleiterschichten, mit
einer ersten Teilzelle (SC1) mit einer ersten Bandlücke und mit einer ersten Gitterkonstanten, und
einer zweiten Teilzelle (SC2) mit einer zweiten Bandlücke und mit einer zweiten Gitterkonstanten, und
einer zwischen den beiden Teilzellen (SC1, SC2) angeordneten Zwischenschichtfolge, wobei die Zwischenschichtfolge eine erste Barriereschicht (B1) und eine Tunneldiode (TD1) und eine zweite Barriereschicht (B2) aufweist, und wobei die Tunneldiode (TD1) eine entartete n+-Schicht mit einer dritten Gitterkonstanten und eine entartete p+-Schicht mit einer vierten Gitterkonstanten aufweist, und die Schichten in der genannten Reihenfolge angeordnet sind,
die vierte Gitterkonstante kleiner als die dritte Gitterkonstante ist, und die erste Bandlücke kleiner ist als die zweite Bandlücke ist, und
die p+-Schicht eine andere Materialkomposition als die n+-Schicht aufweist, und
in einer ersten Alternative die erste Teilzelle (SC1) und die zweite Teilzelle (SC2) zueinander gitterangepasst sind, und
die entartete p+-Schicht eine Gitterfehlanpassung von mindestens 0.5% aufweist und die Gitterkonstante der p+-Schicht eine kleinere Gitterkonstante als die erste Gitterkonstante und die zweite Gitterkonstante aufweist, und die dritte Gitterkonstante der entarteten n+-Schicht gitterangepasst zu der ersten Gitterkonstanten oder zu der zweiten Gitterkonstanten ist,
in einer zweiten Alternative zwischen der ersten Teilzelle (SC1) und der zweiten Teilzelle (SC2) ein metamorpher Puffer (MP) ausgebildet ist, wobei die p+-Schicht der Tunneldiode (TD1) weder zu der ersten Teilzelle (SC1) noch zu der zweiten Teilzelle (SC2) gitterangepasst ist und die vierte Gitterkonstante zwischen der ersten Gitterkonstante und der zweiten Gitterkonstanten liegt, und
die entartete n+-Schicht gitterangepasst zu der ersten Teilzelle (SC1) oder zu der zweiten Teilzelle (SC2) ist, wobei die p+-Schicht min. 5% Indium enthält und als Dotierstoff Kohlenstoff enthält, und
die Schichten der Tunneldiode (TD1) und die weiteren Schichten (B1, B2) der Zwischenschichtfolge zueinander nicht spannungskompensiert sind.

2. Solarzellenstapel (ST) nach Anspruch 1, **dadurch gekennzeichnet, dass** die entartete p+-Schicht der Tunneldiode (TD1) eine Gitterfehlanpassung zur entarteten n+-Schicht der Tunneldiode (TD1) zwischen 0.5% und 2.0% aufweist.

3. Solarzellenstapel (ST) nach einem der vorangegangenen Ansprüche, **dadurch gekennzeichnet, dass** die entartete p+-Schicht der Tunneldiode (TD1) eine AlInGaAs-Materialkomposition umfasst oder aus einer Materialkomposition von AlInGaAs besteht, wobei die Kohlenstoffkonzentration im Material größer als 1E19 cm⁻³ ist.

4. Solarzellenstapel (ST) nach einem der vorangegangenen Ansprüche, **dadurch gekennzeichnet, dass** der Indium-Gehalt der entarteten p+-Schicht der Tunneldiode (TD1), bestehend aus AlInGaAs, zwischen 5% und 20% und der Aluminium-Gehalt der entarteten p+-Schicht der Tunneldiode (TD1) zwischen 10% und 80% liegt.

5. Solarzellenstapel (ST) nach einem der vorangegangenen Ansprüche, **dadurch gekennzeichnet, dass** die Gitterkonstante der entarteten p+-Schicht der Tunneldiode (TD1) zwischen 5.674 Å und 5.734 Å liegt.

6. Solarzellenstapel (ST) nach einem der vorangegangenen Ansprüche, **dadurch gekennzeichnet, dass** die entartete p+-Schicht der Tunneldiode (TD1) kein Antimon oder bis zu maximal 5% Antimon enthält.

7. Solarzellenstapel (ST) nach Anspruch 1 und 2, **dadurch gekennzeichnet, dass** die entartete n+-Schicht der Tunneldiode (TD1) aus der Verbindung aus InGaP, AlInGaP oder AlInP besteht und mit Tellur, Silizium, Selen oder Germanium dotiert ist und die Gitterkonstante zwischen 5.714 Å und 5.785 Å liegt.

8. Solarzellenstapel (ST) nach Anspruch 7, **dadurch gekennzeichnet, dass** der Indium-Gehalt der entarteten n+-Schicht der Tunneldiode (TD1) zwischen 63% und 80% liegt und der Aluminium-Gehalt bis zu 37% beträgt.

9. Solarzellenstapel (ST) nach einem der vorangegangenen Ansprüche, **dadurch gekennzeichnet, dass** der Solarzellenstapel (ST) ein Ge oder GaAs Substrat aufweist.

10. Solarzellenstapel (ST) nach Anspruch 9, **dadurch gekennzeichnet, dass** das Ge Substrat eine n+-Schicht aufweist und eine Ge-Teilzelle als unterste Teilzelle (SC1) ausbildet.

11. Solarzellenstapel (ST) nach einem der vorangegangenen Ansprüche, **dadurch gekennzeichnet, dass** in der stapelförmig aufrecht metamorphen vierfach Mehrfachsolarzelle die Tunneldiode (TD1) ein- bis zweimal vorhanden ist und sich jeweils zwischen zwei Teilzellen befindet, wobei drei der vier Teilzellen oberhalb des metamorphen Puffers angeordnet sind.

12. Solarzellenstapel (ST) nach einem der vorangegangenen Ansprüche, **dadurch gekennzeichnet, dass** die Tunneldiode (TD1) ein- bis dreimal in der stapelförmig monolithischen aufrecht metamorphen vierfach Mehrfachsolarzelle vorhanden ist und sich davon einmal zwischen metamorphem Puffer (MP) und darüber liegender Teilzelle und ein- bis zweimal zwischen zwei benachbarten Teilzellen befindet, wobei drei der vier Teilzellen oberhalb des metamorphen Puffers (MP) angeordnet sind.

13. Solarzellenstapel (ST) nach einem der vorangegangenen Ansprüche, **dadurch gekennzeichnet, dass** die Tunneldiode (TD1) ein- bis dreimal in der stapelförmig aufrecht metamorphen fünffach Mehrfachsolarzelle vorhanden ist und sich jeweils zwischen zwei Teilzellen befindet, wobei vier der fünf Teilzellen oberhalb des metamorphen Puffers (MP) angeordnet sind.

14. Solarzellenstapel (ST) nach einem der vorangegangen Ansprüche, **dadurch gekennzeichnet, dass** die Tunneldiode (TD1) ein- bis viermal in der stapelförmig aufrecht metamorphen fünffach Mehrfachsolarzelle vorhanden ist und sich davon einmal zwischen metamorphem Puffer (MP) und darüber liegender Teilzelle und ein- bis dreimal zwischen zwei benachbarten Teilzellen befindet, wobei vier der fünf Teilzellen oberhalb des metamorphen Puffers (MP) angeordnet sind.

15. Solarzellenstapel (ST) nach einem der vorangegangenen Ansprüche, **dadurch gekennzeichnet, dass** die Schichten des metamorphen Puffers in der zweiten Ausführungsform aus Materialkompositionen von InGaAs und/oder AlInGaAs und/oder InGaP bestehen und der metamorphe Puffer eine Abfolge von mindestens drei Schichten aufweist und die Gitterkonstante bei der Abfolge in Richtung zu der zweiten Teilzelle von Schicht zu Schicht ansteigt und wobei die Gitterkonstanten der Schichten des Puffers größer als die Gitterkonstante der ersten Teilzelle (SC1) sind und wobei eine Schicht des metamorphen Puffers (MP) eine dritte Gitterkonstante aufweist und die dritte Gitterkonstante größer als die Gitterkonstante der zweiten Teilzelle (SC2) ist.

16. Solarzellenstapel (ST) nach einem der vorangegangenen Ansprüche, **dadurch gekennzeichnet, dass** die p+-Schicht der Tunneldiode (TD1) nicht spannungskompensiert durch eine darauffolgende Schicht im Solarzellenstapel (ST) ist.

17. Solarzellenstapel (ST) nach einem der vorangegangenen Ansprüche, **dadurch gekennzeichnet, dass** der Solarzellenstapel (ST) monolithisch ausgebildet ist.

## Claims

1. Solar cell stack (ST) comprising predominantly III-V semiconductor layers, comprising
a first part cell (SC1) with a first band gap and a first lattice constant, and
a second part cell (SC2) with a second band gap and a second lattice constant, and
an intermediate layer sequence arranged between the two part cells (SC1, SC2), wherein the intermediate layer sequence comprises a first barrier layer (B1), a tunnel diode (TD1) and a second barrier layer (B2), and wherein the tunnel diode (TD1) comprises a degenerated n+ layer with a third lattice constant and a degenerated p+ layer with a fourth lattice constant, and the layers are arranged in the stated sequence,
the fourth lattice constant is smaller than the third lattice constant and the first band gap is smaller than the second band gap and
the p+ layer has a material composition different from that of the n+ layer, and
in a first alternative the first part cell (SC1) and the second part cell (SC2) are lattice-matched to one another, and
the degenerated p+ layer has a lattice void adaptation of at least 0.5% and the lattice constant of the p+ layer has a smaller lattice constant than the first lattice constant and the second lattice constant, and the third lattice constant of the degenerated n+ layer is lattice-adapted to the first lattice constant or to the second lattice constant,
in a second alternative a metamorphic buffer (MP) is constructed between the first part cell (SC1) and the second part cell (SC2), wherein the p+ layer of the tunnel diode (TD1) is lattice-adapted neither to the first part cell (SC1) nor to the second part cell (SC2) and the fourth lattice constant lies between the first lattice constant and the second lattice constant, and
the degenerated n+ layer is lattice-adapted to the first part cell (SC1) or to the second part cell (SC2),
wherein
the p+ layer contains a minimum of 5% indium and carbon as doping material and
the layers of the tunnel diode (TD1) and the further layers (B1, B2) of the intermediate layer sequence are not tension-compensated with respect to one another.

2. Solar cell stack (ST) according to claim 1, **characterised in that** the degenerated p+ layer of the tunnel diode (TD1) has a lattice void adaptation to the degenerated n+ layer of the tunnel diode (TD1) between 0.5% and 2.0%.

3. Solar cell stack (ST) according to any one of the preceding claims, **characterised in that** the degenerated p+ layer of the tunnel diode (TD1) has an AlInGaAs material composition or consists of a material composition of AlInGaAs, wherein the carbon concentration in the material is greater than 1E19 cm⁻³.

4. Solar cell stack (ST) according to any one of the preceding claims, **characterised in that** the indium content of the degenerated p+ layer of the tunnel diode (TD1), consisting of AlInGaAs, lies between 5% and 20% and the aluminium content of the degenerated p+ layer of the tunnel diode (TD1) lies between 10% and 80%.

5. Solar cell stack (ST) according to any one of the preceding claims, **characterised in that** the lattice constant of the degenerated p+ layer of the tunnel diode (TD1) lies between 5.674 Å and 5.734 Å.

6. Solar cell stack (ST) according to any one of the preceding claims, **characterised in that** the degenerated p+ layer of the tunnel diode (TD1) contains no antimony or up to at most 5% antimony.

7. Solar cell stack (ST) according to claim 1 and 2, **characterised in that** the degenerated n+ layer of the tunnel diode (TD1) consists of the compound InGaP, AlInGaP or AlInP and is doped with tellurium, silicon, selenium or germanium and the lattice constant lies between 5.714 Å and 5.785 Å.

8. Solar cell stack (ST) according to claim 7, **characterised in that** the indium content of the degenerated n+ layer of the tunnel diode (TD1) lies between 63% and 80% and the aluminium content is up to 37%.

9. Solar cell stack (ST) according to any one of the preceding claims, **characterised in that** the solar cell stack (ST) comprises a Ge or GaAs substrate.

10. Solar cell stack (ST) according to claim 9, **characterised in that** the Ge substrate has an n+ layer and forms a Ge part cell as lowermost part cell (SC1).

11. Solar cell stack (ST) according to any one of the preceding claims, **characterised in that** the tunnel diode (TD1) is present one or twice in the stack-shaped upright metamorphic quadruple multiple solar cell and is respectively present between two part cells, wherein three of the four part cells are arranged above the metamorphic buffer.

12. Solar cell stack (ST) according to any one of the preceding claims, **characterised in that** the tunnel diode (TD1) is present once to three times in the stack-shaped monolithic upright metamorphic quadruple multiple solar cell and, of that, is disposed once between metamorphic buffer (MP) and part cell lying thereabove and once or twice between two adjacent part cells, wherein three of the four part cells are arranged above the metamorphic buffer (MP).

13. Solar cell stack (ST) according to any one of the preceding claims, **characterised in that** the tunnel diode (TD1) is present once to three times in the stack-shaped upright metamorphic quintuple multiple solar cell and is respectively disposed between two part cells, wherein four of the five part cells are arranged above the metamorphic buffer (MP).

14. Solar cell stack (ST) according to any one of the preceding claims, **characterised in that** the tunnel diode (TD1) is present once to four times in the stack-shaped upright metamorphic quintuple multiple solar cell and, of that, is disposed once between metamorphic buffer (MP) and part cell disposed thereabove and once to three times between two adjacent part cells, wherein four of the five part cells are arranged above the metamorphic buffer (MP).

15. Solar cell stack (ST) according to any one of the preceding claims, **characterised in that** the layers of the metamorphic buffer in the second form of embodiment consist of material compositions of InGaAs and/or AIInGaAs and/or InGaP and the metamorphic buffer comprises a sequence of at least three layers and the lattice constant in the sequence increases from layer to layer in the direction towards the second part cell and wherein the lattice constants of the layers of the buffer are greater than the lattice constant of the first part cell (SC1) and wherein a layer of the metamorphic buffer (MP) has a third lattice constant and the third lattice constant is greater than the lattice constant of the second part cell (SC2).

16. Solar cell stack (ST) according to any one of the preceding claims, **characterised in that** the p+ layer of the tunnel diode (TD1) is not tension-compensated by a succeeding layer in the solar cell stack (ST).

17. Solar cell stack (ST) according to any one of the preceding claims, **characterised in that** the solar cell stack (ST) is of monolithic construction.

## Revendications

1. Empilement de cellules solaires (ST) présentant principalement des couches de semi-conducteur des groupes III-V, avec
une première cellule partielle (SC1) avec une première bande interdite et avec une première constante de réseau, et
une deuxième cellule partielle (SC2) avec une deuxième bande interdite et avec une deuxième constante de réseau, et
une succession de couches intermédiaires disposées entre les deux cellules partielles (SC1, SC2), dans lequel la succession de couches intermédiaires présente une première couche de barrière (B1) et une diode tunnel (TD1) et une deuxième couche de barrière (B2) et dans lequel la diode tunnel (TD1) présente une couche n+ dégénérée avec une troisième constante de réseau et une couche p+ dégénérée avec une quatrième constante de réseau et les couches sont disposées dans l'ordre indiqué,
la quatrième constante de réseau est inférieure à la troisième constante de réseau, et
la première bande interdite est plus petite que la deuxième bande interdite et
la couche p+ présente une autre composition de matière que la couche n+ et
dans une première alternative la première cellule partielle (SC1) et la deuxième cellule partielle (SC2) sont en correspondance de réseau l'une avec l'autre et
la couche p+ dégénérée présente un défaut de correspondance de réseau d'au moins 0,5 % et la constante de réseau de la couche p+ présente une constante de réseau inférieure à la première constante de réseau et à la deuxième constante de réseau, et la troisième constante de réseau de la couche n+ dégénérée est en correspondance de réseau avec la première constante de réseau ou la deuxième constante de réseau,
dans une deuxième alternative, un tampon métamorphe (MP) est formé entre la première cellule partielle (SC1) et la deuxième cellule partielle (SC2),
dans lequel la couche p+ de la diode tunnel (TD1) n'est en correspondance de réseau ni avec la première cellule partielle (SC1) ni avec la deuxième cellule partielle (SC2) et la quatrième constante de réseau se situe entre la première constante de réseau et la deuxième constante de réseau et
la couche n+ dégénérée est en correspondance de réseau avec la première cellule partielle (SC1) ou la deuxième cellule partielle (SC2),
dans lequel la couche p+ contient au minimum 5 % d'indium et contient du carbone comme substance dopante et
les couches de la diode tunnel (TD1) et des autres couches (B1, B2) de la succession de couches intermédiaires ne sont pas compensées en tension l'une par rapport à l'autre.

2. Empilement de cellules solaires (ST) selon la revendication 1, **caractérisé en ce que** la couche p+ dégénérée de la diode tunnel (TD1) présente un défaut de correspondance de réseau compris entre 0,5 % et 2,0 % par rapport à la couche n+ dégénérée de la diode tunnel (TD1).

3. Empilement de cellules solaires (ST) selon l'une quelconque des revendications précédentes, **caractérisé en ce que** la couche p+ dégénérée de la diode tunnel (TD1) comprend une composition de matière de AlInGaAs ou se compose d'une composition de matière de AlInGaAs, dans lequel la concentration en carbone de la matière est supérieure à 1E19 cm⁻³.

4. Empilement de cellules solaires (ST) selon l'une quelconque des revendications précédentes, **caractérisé en ce que** la teneur en indium de la couche p+ dégénérée de la diode tunnel (TD1), se composant de AlInGaAs, se situe entre 5 % et 20 % et la teneur en aluminium de la couche p+ dégénérée de la diode tunnel (TD1) se situe entre 10 % et 80 %.

5. Empilement de cellules solaires (ST) selon l'une quelconque des revendications précédentes, **caractérisé en ce que** la constante de réseau de la couche p+ dégénérée de la diode tunnel (TD1) se situe entre 5,674 Å et 5,734 Å.

6. Empilement de cellules solaires (ST) selon l'une quelconque des revendications précédentes, **caractérisé en ce que** la couche p+ dégénérée de la diode tunnel (TD1) ne contient pas d'antimoine ou au maximum 5 % d'antimoine.

7. Empilement de cellules solaires (ST) selon une des revendications 1 ou 2, **caractérisé en ce que** la couche n+ dégénérée de la diode tunnel (TD1) se compose du composé de InGaP, AlInGaP ou AlInP et est dopée avec du tellure, du silicium, du sélénium ou du germanium et la constante de réseau se situe entre 5,714 Å et 5,785 Å.

8. Empilement de cellules solaires (ST) selon la revendication 7, **caractérisé en ce que** la teneur en indium de la couche n+ dégénérée de la diode tunnel (TD1) se situe entre 63 % et 80 % et la teneur en aluminium vaut jusque 37 %.

9. Empilement de cellules solaires (ST) selon l'une quelconque des revendications précédentes, **caractérisé en ce que** l'empilement de cellules solaires (ST) présente un substrat de Ge ou de GaAs.

10. Empilement de cellules solaires (ST) selon la revendication 9, **caractérisé en ce que** le substrat de Ge présente une couche n+ et forme une cellule partielle au Ge comme cellule partielle inférieure (SC1).

11. Empilement de cellules solaires (ST) selon l'une quelconque des revendications précédentes, **caractérisé en ce que** la diode tunnel (TD1) est présente une à deux fois dans la cellule solaire multiple quadruple métamorphe dressée en forme d'empilement et elle se trouve respectivement entre deux cellules partielles, dans lequel trois des quatre cellules partielles sont disposées au-dessus du tampon métamorphe.

12. Empilement de cellules solaires (ST) selon l'une quelconque des revendications précédentes, **caractérisé en ce que** la diode tunnel (TD1) est présente une à trois fois dans la cellule solaire multiple quadruple métamorphe dressée en forme d'empilement monolithique et de celles-là se trouve une fois entre le tampon métamorphe (MP) et la cellule partielle sus-jacente et une à deux fois entre deux cellules partielles voisines, dans lequel trois des quatre cellules partielles sont disposées au-dessus du tampon métamorphe (MP).

13. Empilement de cellules solaires (ST) selon l'une quelconque des revendications précédentes, **caractérisé en ce que** la diode tunnel (TD1) est présente une à trois fois dans la cellule solaire multiple quintuple métamorphe dressée en forme d'empilement et se trouve respectivement entre deux cellules partielles, dans lequel quatre des cinq cellules partielles sont disposées au-dessus du tampon métamorphe (MP).

14. Empilement de cellules solaires (ST) selon l'une quelconque des revendications précédentes, **caractérisé en ce que** la diode tunnel (TD1) est présente une à quatre fois dans la cellule solaire multiple quintuple métamorphe dressée en forme d'empilement et de celles-là se trouve une fois entre le tampon métamorphe (MP) et la cellule partielle sus-jacente et une à trois fois entre deux cellules partielles voisines, dans lequel quatre des cinq cellules partielles sont disposées au-dessus du tampon métamorphe (MP).

15. Empilement de cellules solaires (ST) selon l'une quelconque des revendications précédentes, **caractérisé en ce que** les couches du tampon métamorphe dans la deuxième forme de réalisation se composent de compositions de matière de InGaAs et/ou AlInGaAs et/ou InGaP et le tampon métamorphe présente une succession d'au moins trois couches et la constante de réseau dans la succession en direction de la deuxième cellule partielle augmente de couche en couche et dans lequel les constantes de réseau des couches du tampon sont supérieures à la constante de réseau de la première cellule partielle (SC1) et dans lequel une couche du tampon métamorphe (MP) présente une troisième constante de réseau et la troisième constante de réseau est supérieure à la constante de réseau de la deuxième cellule partielle (SC2).

16. Empilement de cellules solaires (ST) selon l'une quelconque des revendications précédentes, **caractérisé en ce que** la couche p+ de la diode tunnel (TD1) n'est pas compensée en tension par une couche suivante dans l'empilement de cellules solaires (ST).

17. Empilement de cellules solaires (ST) selon l'une quelconque des revendications précédentes, **caractérisé en ce que** l'empilement de cellules solaires (ST) est réalisé sous forme monolithique.
